# EUROPEAN PATENT APPLICATION

(11) **EP 4 343 850 A1**
(43) Date of publication of application: **27.03.2024**
(21) Application number: 22885189.5
(22) Date of filing: 07.07.2022
(51) Int. Cl.: H01L 29/423, H01L 29/78, H01L 21/336

(54) **TRENCH-GATE SEMICONDUCTOR DEVICE AND MANUFACTURING METHOD THEREFOR**

(30) Priority: 29.10.2021 CN 202111275645
(71) Applicant: Huawei Digital Power Technologies Co., Ltd., Shenzhen, Guangdong 518043 (CN)
(72) Inventor: GAO, Bo, Shenzhen, Guangdong 518043 (CN); HUANG, Boning, Shenzhen, Guangdong 518043 (CN); TANG, Longgu, Shenzhen, Guangdong 518043 (CN); ZHANG, Yi, Shenzhen, Guangdong 518043 (CN); ZHOU, Feng, Shenzhen, Guangdong 518043 (CN); HU, Fei, Shenzhen, Guangdong 518043 (CN)
(74) Representative: Gill Jennings & Every LLP
(86) International application number: PCT/CN2022/104255
(87) International publication number: WO 2023/071284

(57) **Abstract**

Embodiments of this application disclose a trench gate semiconductor device and a method for manufacturing the trench gate semiconductor device, to improve reliability of the trench gate semiconductor. The trench gate semiconductor in this application includes a substrate having a first conductivity type; an epitaxial layer having the first conductivity type, grown on the substrate; a well region having a second conductivity type, formed on a surface layer of the epitaxial layer; a source region having the first conductivity type, formed on a surface layer of the well region; a first trench, running through the well region from a surface of the source region to the epitaxial layer; a gate, formed in the first trench in a manner of being separated by a gate insulator; and an amorphous semiconductor layer, formed in the first trench and wrapping an outer bottom wall of the gate and corners on two sides of the outer bottom wall in a manner of being separated by the gate insulator, where the amorphous semiconductor layer is made of a low dielectric constant material.

## Description

This application claims priority to Chinese Patent Application No. 202111275645.2, filed with the China National Intellectual Property Administration on October 29, 2021 and entitled "TRENCH GATE SEMICONDUCTOR DEVICE, AND MANUFACTURING METHOD THEREOF", which is incorporated herein by reference in its entirety.

### TECHNICAL FIELD

Embodiments of this application relate to the field of semiconductor technologies, and in particular, to a trench gate semiconductor device and a manufacturing method thereof.

### BACKGROUND

A structure of a trench gate metal-oxide-semiconductor field-effect transistor (MOSFET) device has high electron mobility and a low JFET resistance effect in a vertical channel, so that on resistance of the trench gate device is much less than on resistance of a planar gate device of a same size.

However, because the device bears a high voltage after reverse blocking, an oxide layer at the bottom of a trench gate bears a high electric field, and a risk of breakdown of the oxide layer of the trench gate is exacerbated.

### SUMMARY

Embodiments of this application provide a trench gate semiconductor device and a method for manufacturing the trench gate semiconductor device, to improve reliability of the trench gate semiconductor device.

A first aspect of embodiments of this application provides a trench gate semiconductor device. The trench gate semiconductor device includes a substrate, an epitaxial layer, a well region, a source region, a first trench, a gate, a gate insulator, and an amorphous semiconductor layer. The substrate is of a first conductivity type. The epitaxial layer is of the first conductivity type, and is grown on the substrate. The well region is of a second conductivity type, and is formed on a surface layer of the epitaxial layer. The source region is of the first conductivity type, and is formed on a surface layer of the well region. The first trench runs through the well region from a surface of the source region to the epitaxial layer, and the gate is formed in the first trench in a manner of being separated by the gate insulator. The first conductivity type is a P type, and the second conductivity type is an N type. Alternatively, the first conductivity type is the N type, and the second conductivity type is the P type. The P-type conductivity type is formed by doping acceptor impurities such as aluminum ions, boron ions, or gallium ions, and the N-type conductivity type is formed by doping N-type donor impurities such as nitrogen ions or phosphorus ions. The amorphous semiconductor layer is formed in the first trench and wraps an outer bottom wall of the gate and corners on two sides of the outer bottom wall in a manner of being separated by the gate insulator, where the amorphous semiconductor layer is made of a low dielectric constant material. An outer wall of the gate is wrapped by an oxide layer, and a bottom of the gate is further wrapped by the amorphous semiconductor layer of the low dielectric constant, to improve breakdown field strength at the bottom of the trench gate, thereby improving reliability of the oxide layer of the gate.

In some possible implementations, a thickness of the amorphous semiconductor layer is greater than 0.1 µm.

In some possible implementations, the trench gate semiconductor device further includes a shield layer having the second conductivity type, formed on the epitaxial layer at a bottom of the first trench, where the shield layer wraps the amorphous semiconductor layer, and extends in an arc chamfer to the gate insulator on the corners or side walls of the gate. The shield layer can form a PN junction with the substrate, so that a voltage borne by the gate insulator at a position of the corner of the gate is reduced, and reliability of the trench gate semiconductor device is improved.

In some possible implementations, a junction depth of the shield layer is greater than or equal to 0.4 µm.

In some possible implementations, the corner of the gate is arc-shaped on a longitudinal section of the trench gate semiconductor device. In this way, extrusion on electric field lines between the gate and the drain can be reduced, to reduce a voltage borne by the gate insulator at the position of the corner of the gate.

In some possible implementations, the epitaxial layer includes a first sub epitaxial layer and a second sub epitaxial layer, the first sub epitaxial layer is located between the substrate and the second sub epitaxial layer, the well region, the source region, and the amorphous semiconductor layer are formed on the second sub epitaxial layer, and a doping concentration of the first sub epitaxial layer is less than a doping concentration of the substrate, and is greater than a doping concentration of the second sub epitaxial layer. In this way, on resistance of the epitaxial layer can be reduced.

In some possible implementations, the trench gate semiconductor device further includes: a contact region having the second conductivity type, connected to the well region, where a doping concentration of the contact region is greater than a doping concentration of the well region; a source, connected to the source region and the contact region; and a drain, connected to a surface of the substrate that is away from the epitaxial layer. The surface doping concentration of the contact region is greater than the surface doping concentration of the well region, and the contact region is used to connect to the source, so that resistivity of the well region can be reduced.

In some possible implementations, a semiconductor material that forms the substrate and the epitaxial layer is silicon carbide, and/or the amorphous semiconductor is amorphous silicon carbide. The silicon carbide has excellent physical characteristics such as a wide band gap, high critical breakdown field strength, and high thermal conductivity, so that a silicon carbide semiconductor device has advantages such as high voltage endurance, high temperature endurance, a high switching speed, and low switching loss.

A second aspect of embodiments of this application provides a method for manufacturing a trench gate semiconductor device. The manufacturing method includes: depositing an epitaxial layer having a first conductivity type on a substrate having the first conductivity type; injecting ions of a second conductivity type into a surface layer of the epitaxial layer to form a well region; injecting ions of the first conductivity type into a surface layer of the well region to form a source region; performing photoetching on a surface of the source region to form a first trench running through the well region to the epitaxial layer; injecting ions of the second conductivity type into a bottom wall and corners of the first trench to form an amorphous semiconductor layer; and growing a gate insulator in the first trench, and performing deposition and doping to form a gate of a poly gate structure. After the trench is formed, ion injection is performed at the bottom of the trench. To be specific, a requirement on a junction depth of the amorphous semiconductor layer is not high, a process is simple, performance parameters of a process device are low, and manufacturing costs are low.

In some possible implementations, before injecting the ions into the bottom wall and a part of a side wall of the first trench to form the amorphous semiconductor layer, the method includes: depositing a hard mask on side walls of the first trench; and injecting ions of the second conductivity type into the bottom wall and the corners of the first trench to form a shield layer, where an injection depth of the shield layer is greater than an injection depth of the amorphous semiconductor layer, and a doping concentration of the shield layer is less than a doping concentration of the amorphous semiconductor layer.

In some possible implementations, an injection junction depth of the shield layer is greater than or equal to 0.4 µm.

In some possible implementations, a thickness of the amorphous semiconductor layer is greater than or equal to 0.1 µm.

In some possible implementations, the corner of the gate is arc-shaped on a longitudinal section of the trench gate semiconductor device.

### BRIEF DESCRIPTION OF DRAWINGS

FIG. 1 is a schematic diagram of a structure of an embodiment of a trench gate semiconductor device according to this application;
FIG. 2 is a schematic flowchart of an embodiment of a method for manufacturing a trench gate semiconductor device according to this application;
FIG. 3 is a schematic flowchart of another embodiment of a method for manufacturing a trench gate semiconductor device according to this application; and
FIG. 4 is a schematic flowchart of still another embodiment of a method for manufacturing a trench gate semiconductor device according to this application.

### DESCRIPTION OF EMBODIMENTS

Embodiments of this application provide a trench gate semiconductor device and a method for manufacturing the trench gate semiconductor device, to improve reliability of the trench gate semiconductor device.

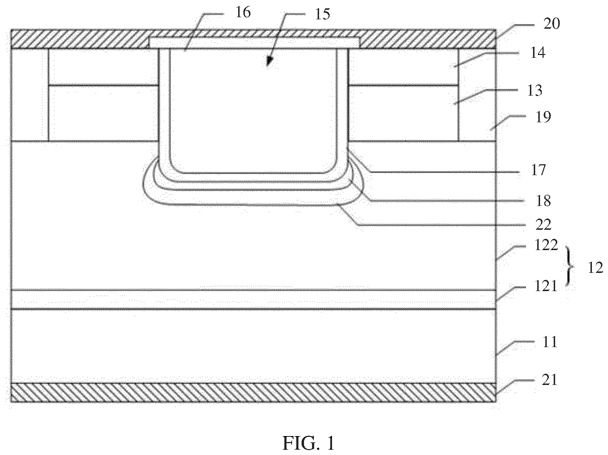

FIG. 1 is a schematic diagram of a structure of an embodiment of a trench gate semiconductor device according to this application. It may be understood that thicknesses, widths, and the like of regions in FIG. 1 are merely used as examples, and are not intended to limit a structure of the trench gate semiconductor in this application. A plurality of semiconductor devices having a same structure as the trench gate semiconductor device shown in FIG. 1 are arranged in a manner of strip arrangement, square arrangement, hexagon arrangement, or atomic lattice arrangement, to form a poly-cell semiconductor device. The trench gate semiconductor device 100 in this embodiment includes a substrate 11, an epitaxial layer 12, a well region 13, a source region 14, a first trench 15, a gate 16, a gate insulator 17, an amorphous semiconductor layer 18, a contact region 19, a source 20, and a drain 21.

The substrate 11 is of a first conductivity type. The epitaxial layer 12 is grown on the substrate 11, and is also of the first conductivity type. The well region 13 is formed on a surface layer of the epitaxial layer 12, and is of a second conductivity type. The source region 14 is formed on a surface layer of the well region 13, and is of the first conductivity type. The first trench 15 runs through the well region 13 from a surface of the source region 14 to the epitaxial layer 12. The gate 16 is formed in the first trench 15 in a manner of being separated by the gate insulator 17. The amorphous semiconductor layer 18 is formed in the first trench 15 and wraps an outer bottom wall of the gate 16 and corners on two sides of the outer bottom wall in a manner of being separated by the gate insulator 17. The source region 14 and the well region 13 are located on two sides of the gate 16, and the contact region 19 is located on one side of the source region 14 and/or the well region 13 that is away from the gate 16. The contact region 19 is connected to the well region 13, the source 20 is connected to the source region 14 and the contact region 19, and the drain 21 is connected to a surface of the substrate 11 that is away from the epitaxial layer 12.

In this embodiment of this application, the first conductivity type may be an N type, the second conductivity type is a P type, and the trench gate semiconductor device 100 is an inverse trench gate metal-oxide-semiconductor field-effect transistor (MOSFET) device on which an N trench is formed. Certainly, the first conductivity type may alternatively be the P type, the second conductivity type is the N type, and the trench gate semiconductor device 100 is a MOSFET device on which a P channel is formed. This application is described by using an example in which the first conductivity type may be the N type and the second conductivity type is the P type.

The substrate 11 is doped with N-type impurities such as nitrogen ions or phosphorus ions, so that resistivity of the substrate 11 reaches 0.01 Ω•cm to 0.025 Ω•cm. A thickness of the substrate 11 is approximately 150 microns (um), and is specifically, for example, 145 µm, 150 µm, or 155 µm.

An N-type ion doping concentration of the epitaxial layer 12 is less than an N-type ion doping concentration of the substrate 11. A thickness of the epitaxial layer 12 is approximately 11 µm, and is specifically, for example, 10.5 µm, 11 µm, 11.5 µm, or 12 µm.

Optionally, the epitaxial layer 12 may include a first sub epitaxial layer 121 and a second sub epitaxial layer 122. The first sub epitaxial layer 121 is located between the substrate 11 and the second sub epitaxial layer 122. The well region 13, the source region 14, and the amorphous semiconductor layer 18 are formed on the second sub epitaxial layer 122. A doping concentration of the first sub epitaxial layer 121 is less than a doping concentration of the substrate 11, and is greater than a doping concentration of the second sub epitaxial layer 122. A thickness of the first sub epitaxial layer 121 is approximately 0.5 µm, and is specifically, for example, 0.4 µm, 0.5 µm, or 0.6 µm. A thickness of the second sub epitaxial layer 122 is approximately 11 µm, and is specifically, for example, 10 µm, 10.6 µm, 11 µm, or 11.4 µm. Doping concentration distribution of the first sub epitaxial layer 121 may be a single concentration, a stepped concentration, or a slowly varying concentration. When the doping concentration of the first sub epitaxial layer 121 is the stepped concentration or the slowly varying concentration, the doping concentration on a side close to the substrate 11 is greater than the doping concentration on a side away from the substrate 11. In this way, on resistance of the epitaxial layer 12 can be reduced.

The well region 13 is specifically formed by injecting ions into the surface layer of the epitaxial layer 12, and the injected ions may be P-type impurities such as aluminum ions, boron ions, or gallium ions. Injection concentration distribution of the P-type impurities of the well region 13 is uniform distribution, an injection junction depth is greater than or equal to 0.5 µm, and the injection junction depth is less than the thickness of the second sub epitaxial layer 122.

The source region 14 is specifically formed by injecting ions into the surface layer of the well region 13, and the injected ions may be N-type impurities such as nitrogen ions or boron ions. A surface injection concentration of the N-type impurities of the source region 14 is greater than 1.0×1019/cm3, and the injection junction depth is approximately 0.2 µm. A thickness of the source region 14 may be specifically, for example, 0.18 µm, 0.19 µm, 2 µm, or 2.1 µm.

Conductivity types of the contact region 19 and the well region 13 are both P-type, and the contact region 19 and the well region 13 have a connection relationship with each other. The contact region 19 is used to connect to the source 20, and a surface doping concentration of the contact region 19 is greater than 1.0×1019/cm3, and is greater than a doping concentration of the well region 13. In this way, resistivity of the well region 13 can be reduced, and avalanche energy and reliability of the semiconductor device can be improved.

In some implementations, the contact region 19 may be formed by selectively injecting P-type impurities such as aluminum ions, boron ions, or gallium ions into the surface layer of the epitaxial layer 12, and an injection junction depth is greater than an injection junction depth of the source region 14, so that the contact region 19 is connected to the well region 13. In this case, there is no trench between a surface layer of the contact region 19 and the surface layer of the source region 14, and a manufacturing process is simple.

In some other implementations, the contact region 19 may alternatively be formed by injecting P-type impurities near the well region 13 after the epitaxial layer 12 is etched to form a second trench (not shown in the figure). The source 20 extends into the second trench and is connected to the contact region 19, to implement trench contact. In this way, a distance between the source and the drain can be reduced, to reduce on resistance of the trench gate semiconductor device 100.

Optionally, the source region 14, the well region 13, and the contact region 19 are symmetrically distributed on two sides of the first trench 15.

The first trench 15 is specifically formed by selectively performing photoetching and etching on the surface of the source region 14, and an etching depth is greater than a sum of depths of the source region 14 and the well region 13, so that the first trench 15 runs downward through the source region 14 and the well region 13 from the surface of the source region 14 to the epitaxial layer 12. A depth of the first trench 15 is greater than 0.7 µm, and is less than a sum of thicknesses of the second epitaxial layer 122, the well region 13, and the source region 14. A side wall of the first trench 15 is perpendicular to or approximately perpendicular to the surface of the source region 14, and a bottom wall of the first trench 15 is parallel to or approximately parallel to the surface of the source region 14. A corner of the first trench 15 is arc-shaped, that is, arc transition occurs at a joint between the side wall and the bottom wall of the first trench 15, to reduce extrusion of the corner of the first trench 15 on an electric field between the gate 16 and the drain 21, reduce an electric field of the corner of the first trench 15, and improve reliability of the trench gate.

The amorphous semiconductor layer 18 is formed by injecting boron ions at a low temperature into the epitaxial layer 12 that is exposed on the bottom wall and at least some corners of the first trench 15, so that the amorphous semiconductor layer 18 covers the bottom wall and the at least some corners of the first trench 15. A boron ion injection concentration of the amorphous semiconductor layer 18 is 1.0×1014/cm3, and a thickness of the amorphous semiconductor is greater than or equal to 0.1 µm. The amorphous semiconductor layer 18 has a low dielectric constant and is insulated or semi-insulated. The amorphous semiconductor layer 18 may be made of a material of a dielectric constant that is approximately 8.9, and may be specifically made of amorphous silicon carbide, or certainly may be made of another amorphous semiconductor material that meets a dielectric constant requirement. This is not limited in this application. The amorphous silicon carbide has characteristics of high electron mobility, a high saturated electron drift velocity, and high breakdown field strength, so that reliability of the trench gate semiconductor device 100 can be improved.

Alternatively, both the substrate 11 and the epitaxial layer 12 may be made of the silicon carbide material. The silicon carbide has excellent physical characteristics such as a wide band gap, high critical breakdown field strength, and high thermal conductivity, so that a silicon carbide semiconductor device has advantages such as high voltage endurance, high temperature endurance, a high switching speed, and low switching loss. Certainly, the substrate and the epitaxial layer may alternatively be made of another wide band gap material such as gallium nitride. This is not limited in this application.

The gate insulator 17 is grown on and covers the side walls, the bottom wall, and the corners of the first trench 15, and is used to isolate contact between the gate 16 and the epitaxial layer 12, the well region 13, and the source region 14. A thickness of the gate insulator 17 is greater than 50 nanometers (nm), and is less than a half of a width of the first trench 15, that is, the gate insulator 17 cannot completely fill the first trench 15. The thickness of the gate insulator 17 is specifically, for example, 50 nm, 55 nm, or 60 nm. The gate insulator 17 may be specifically a silicon dioxide film, a silicon nitride film, a low dielectric constant film, or the like.

The gate 16 is generated by depositing polysilicon on a surface of the gate insulator 17 in the first trench 15, and the gate 16 completely fills the first trench 15. Because the corner of the first trench 15 is arc-shaped, the gate 16 and the gate insulator 17 are also arc-shaped, so that field strength borne by the gate insulator 17 at the corner of the gate 16 is reduced, and reliability of the gate insulator 17 can be improved. In addition, the amorphous semiconductor layer 18 wraps the gate insulator 17 at the corners and the bottom wall of the gate 16, so that breakdown field strength of the gate insulator 17 can be improved.

The source 20 is specifically formed by depositing metal in the source region 14 and the contact region 19, and the drain 21 is formed by depositing metal on one side away from the epitaxial layer 12. A voltage is applied to the source 20, the drain 21, and the gate 16 to implement turn-on or turn-off of the gate semiconductor device of the first trench 15.

In some other implementations, to further improve reliability of the trench gate semiconductor device 100, the trench gate semiconductor device further includes a shield layer 22. The shield layer 22 is formed by injecting P-type impurities into the epitaxial layer 12 corresponding to the bottom wall and the corners of the first trench 15, and an injection junction depth is greater than an ion injection junction depth of the amorphous semiconductor, and is less than a distance from the bottom wall of the first trench 15 to the first sub epitaxial layer 121. The injection junction depth of the shield layer 22 is, for example, 0.4 µm, 0.5 µm, 0.6 µm, or 0.7 µm. A doping concentration of the shield layer is 4.0×1013/cm3, which is greater than a doping concentration of the second sub epitaxial layer 122. Therefore, when the shield layer 22 further includes N-type ions, the conductivity type is the P-type. Because the conductivity type of the shield layer 22 is the P-type, and the conductivity type of the epitaxial layer 12 is the N-type, the shield layer 22 and the epitaxial layer 12 can form a PN junction, so as to prevent an electric field from being concentrated on the gate insulator 17 at the corner of the gate 16, thereby reducing field strength borne by the gate insulator 17.

An injection range of the shield layer 22 is greater than an injection range of the amorphous semiconductor layer 18, so that the shield layer 22 can wrap the amorphous semiconductor layer 18, and extend in an arc chamfer to the gate insulator 17 on the corners or side walls of the gate 16. In this way, the gate insulator 17 at the corner of the gate 16 is wrapped in a plurality of layers, so that breakdown field strength of the gate insulator 17 can be improved, thereby improving reliability of the trench gate semiconductor device 100.

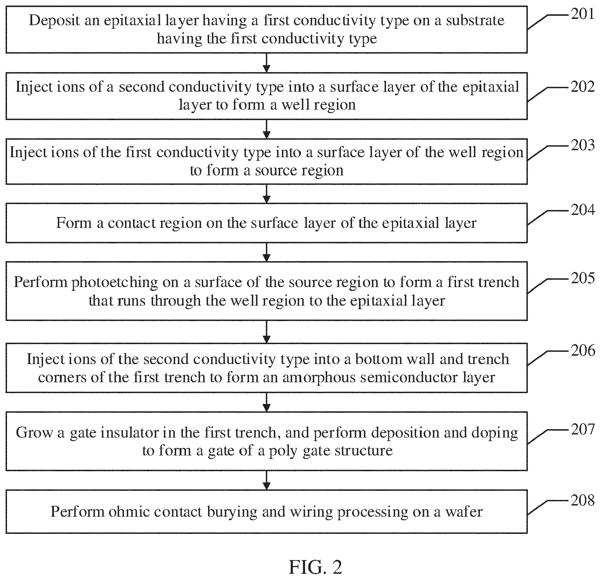

FIG. 2 is a schematic flowchart of an embodiment of a method for manufacturing a trench gate semiconductor device according to this application. The manufacturing method in this embodiment is used to manufacture the foregoing trench gate semiconductor device. When a trench gate semiconductor device with a single trench is manufactured, this embodiment includes the following steps.

201: Deposit an epitaxial layer having a first conductivity type on a substrate having the first conductivity type.

In this application, the first conductivity type may be an N type and the second conductivity type is a P type. Certainly, the first conductivity type may alternatively be the P type, and the second conductivity type is the N type. This embodiment is described by using an example in which the first conductivity type may be the N type and the second conductivity type is the P type.

In this embodiment, both the substrate and the epitaxial layer may be made of a silicon carbide material. The silicon carbide has high critical avalanche breakdown electric field strength, a high carrier saturation drift velocity, high thermal conductivity, and high carrier mobility, so that the trench gate semiconductor device has a capability of withstanding a high voltage, low on-state resistance, good thermal conductivity and thermal stability, and a strong capability of withstanding high temperature and ray radiation. Certainly, the substrate and the epitaxial layer may alternatively be made of another wide band gap material such as gallium nitride. This is not limited in this application.

A first sub epitaxial layer with a thickness of approximately 0.5 µm is grown on a provided N+ (heavily doped with N-type impurities) substrate with resistivity of 0.01 Ω•cm to 0.025 Ω•cm, and N-type impurities (such as nitrogen ions or phosphorus ions) with a concentration less than that of the substrate are injected into the first sub epitaxial layer, so that a conductivity type of the first sub epitaxial layer is an N-type. Then, a second sub epitaxial layer with a thickness of approximately 11 µm continues to be grown on the sub epitaxial layer, and N-type impurities with a concentration less than that of the first sub epitaxial layer are injected into the first sub epitaxial layer, so that a conductivity type of the second sub epitaxial layer is also the N-type.

202: Inject ions of the second conductivity type into a surface layer of the epitaxial layer to form a well region.

Specifically, a silicon dioxide dielectric layer that is used for masking and that has a thickness of approximately 1.5 µm is deposited on the second sub epitaxial layer, and then the silicon dioxide dielectric layer on a surface of the second sub epitaxial layer is selectively removed by using a process such as photoetching or etching, to form a well region injection window. The silicon dioxide dielectric layer that is not etched is used as a masking layer for ion injection. The etching may be performed by using a dry etching method, so that the etching is performed in a direction perpendicular to the surface of the second sub epitaxial layer.

P-type ions are injected into the second sub epitaxial layer by using the well region injection window by using an ion injection method, to form a well region with uniform concentration distribution and a junction depth greater than 0.5 µm. Ion injection is to make ionized elements collide with the epitaxial layer under a high acceleration voltage, so that the ions physically intrude into a lattice of the epitaxial layer.

203: Inject ions of the first conductivity type into a surface layer of the well region to form a source region.

Specifically, the remaining silicon dioxide dielectric layer on a surface layer of a wafer (that is, a trench gate semiconductor device in a processed state) is removed, a silicon dioxide dielectric layer with a thickness of approximately 1.5 µm is deposited again, and the silicon dioxide dielectric layer on the surface of the second sub epitaxial layer is selectively removed by using a photoetching or etching process, to form a source region injection window on the surface layer of the well region.

N-type impurities such as nitrogen ions are injected by using the source region injection window by using the ion injection method, to form an N-type source region with a surface injection concentration greater than 1.0×1019/cm3 and a junction depth of 0.2 µm.

204: Form a contact region on the surface layer of the epitaxial layer.

The remaining silicon dioxide dielectric layer on the surface layer of the wafer is removed, a silicon dioxide dielectric layer with a thickness of approximately 1.5 µm is deposited again, and the silicon dioxide dielectric layer on the surface of the second sub epitaxial layer is selectively removed by using a photoetching or etching process, to form a contact region injection window. The contact region injection window does not overlap a surface of the source region.

P-type impurities such as boron ions or aluminum ions are injected into the second sub epitaxial layer by using the contact region injection window by using the ion injection method, to form a contact region with a surface injection concentration greater than 1.0×1019/cm3 and a junction depth greater than that of the source region. The P-type ion injection concentration of the contact region is greater than the ion injection concentration of the well region.

In an ion injection process, high-energy ions damage a lattice of the wafer. Therefore, after the contact region is formed, the silicon dioxide dielectric layer is removed from the surface of the wafer, a 20 nm carbon film dielectric layer is deposited, and high-temperature annealing processing is performed on the wafer, so as to restore the lattice, and activate ions injected into the epitaxial layer, the well region, the source region, and the contact region. The annealing processing is specifically, for example, rapid thermal anneal (RTA), which can reduce a time of temperature rise and cooling of the wafer, and improve activation efficiency. In addition, because the time is short, a distribution change of impurities can be further suppressed, and the impurities are prevented from spreading to another region. An annealing temperature is greater than or equal to 1600 degrees Celsius and less than a melting point of the substrate and the epitaxial layer. The annealing temperature may be specifically, for example, 1600 degrees Celsius, 1700 degrees Celsius, 1750 degrees Celsius, or the like.

The carbon film is used to suppress the surface of the wafer from becoming rough in the process of high temperature annealing. After annealing, the carbon film is removed by using a plasma etching method.

205: Perform photoetching on the surface of the source region to form a first trench that runs through the well region to the epitaxial layer.

A silicon dioxide dielectric layer with a thickness of approximately 1.5 µm is deposited on the wafer surface, and a part of the silicon dioxide dielectric layer on the wafer surface is selectively removed by using a process such as photoetching or etching, to form a trench gate etching window.

The source region exposed by the trench gate etching window is etched by using an inductively coupled plasma (ICP) technology, to form the first trench that runs through the source region and the well region to the second sub epitaxial layer.

The ICP may provide high-rate, high-selection-ratio, and low-damage etching, plasmas can remain stable at low atmospheric pressure, and therefore can better control an etching profile, to form a profile in which straightness of side walls and a bottom wall is high and there is no micro trench.

206: Inject ions of the second conductivity type into a bottom wall and trench corners of the first trench to form an amorphous semiconductor layer.

Specifically, a silicon dioxide dielectric layer with a thickness of approximately 1.2 µm is deposited on the surface of the wafer, and a trench gate process window is obtained through etching by using a photoetching or etching process. Then, a silicon dioxide dielectric layer with a thickness of approximately 100 nm is deposited on the wafer, and boron ions are injected into the bottom wall and the corners of the first trench through ion injection. A boron ion injection concentration is 1.0×1014/cm3, an injection junction depth is greater than or equal to 0.1 µm, and an injection temperature is less than 50 degrees Celsius, so as to form the amorphous semiconductor layer.

207: Grow a gate insulator in the first trench, and perform deposition and doping to form a gate of a poly gate structure.

Before the gate insulator is grown, a sacrificial oxide layer with a thickness greater than 20 nm is formed on the surface of the wafer (including the first trench) through high temperature oxidation. Then, the sacrificial oxide layer is removed by using a wet process, so as to reduce roughness of the surface of the wafer and make the surface of the wafer smooth.

A silicon dioxide dielectric layer with a thickness of approximately 300 nm is deposited on the surface of the wafer, and an active region of the gate (that is, a region corresponding to the first trench on the surface of the wafer) is obtained through etching by using a process such as photoetching or etching. A 50 nm gate insulator layer is oxidized and grown on the surface of the wafer at a high temperature, a 500 nm polysilicon layer is deposited in the first trench by using a low-pressure chemical vapor phase method, and the polysilicon is in-situ doped, sheet resistance is less than 30 Ω/□, and a poly gate structure is formed by using a photoetching or etching process.

208: Perform ohmic contact burying and wiring processing on the wafer.

Specifically, a silicon dioxide dielectric layer with a thickness of approximately 100 nm and an 800 nm boro-phospho-silicate glass (BPSG) layer are sequentially deposited on the surface of the wafer, and high-temperature reflow is performed at 980°C. The BPSG layer has fluidity at a high temperature, so that the surface of the wafer can be flattened. Then, a silicon dioxide dielectric layer with a thickness of approximately 100 nm is deposited, and an ohmic contact hole process window is formed by using a photoetching or etching process. A nickel (Ni) layer is deposited on the surface of the wafer, and the Ni layer is annealed by using a rapid thermal process (RTP). A silicon-nickel (NiSi) alloy is formed on the surface of the wafer exposed by the ohmic contact hole process window, and then the non-alloyed Ni layer is removed through self-alignment in an acid pickling manner. An aluminum-copper (AlCu) alloy with a thickness of approximately 5 µm continues to be sputtered, and a metal electrode is formed by using a photoetching or etching process. A silicon dioxide or silicon nitride dielectric layer and a polyimide film layer are deposited on the surface of the wafer, and source and gate electrodes on a front surface are formed by using a photoetching or etching process. A back surface of the wafer (that is, one side of the substrate that is away from the epitaxial layer) is thinned to approximately 150 µm by using a process such as etching or polishing. A layer of Ni metal is evaporated on the back surface of the wafer, and high-speed annealing is performed by using laser, to form a NiSi alloy. A plurality of layers of metal: titanium/nickel/silver (Ti/Ni/Ag) are evaporated on the back surface of the wafer, to form a back electrode (that is, a drain).

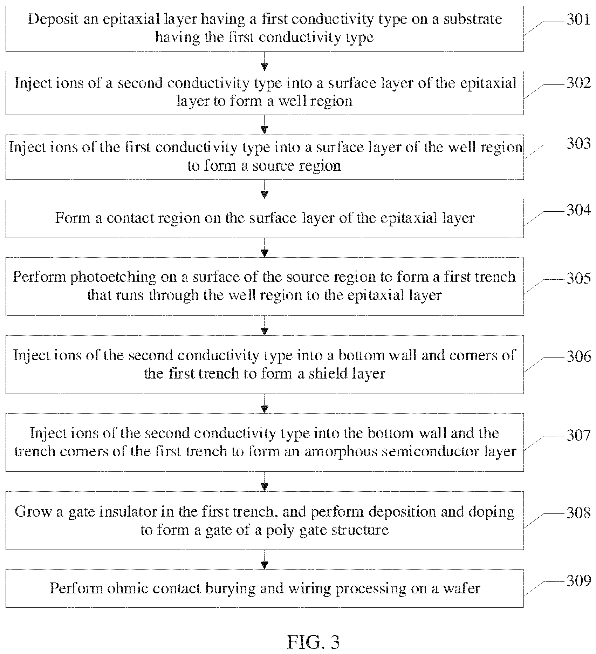

In some other implementations, FIG. 3 is a schematic flowchart of another embodiment of a method for manufacturing a trench gate semiconductor device according to this application. If a trench gate semiconductor device further including a shield layer is manufactured, a manufacturing process is as follows:
301: Deposit an epitaxial layer having a first conductivity type on a substrate having the first conductivity type.
302: Inject ions of the second conductivity type into a surface layer of the epitaxial layer to form a well region.
303: Inject ions of the first conductivity type into a surface layer of the well region to form a source region.

Steps 301 to 303 are the same as steps 201 to 203, and therefore details are not described herein again.

304: Form a contact region on the surface layer of the epitaxial layer.

Different from 204, in this step, high-temperature annealing processing is not performed on the wafer after the contact region is formed.

305: Perform photoetching on the surface of the source region to form a first trench that runs through the well region to the epitaxial layer.

306: Inject ions of the second conductivity type into a bottom wall and corners of the first trench to form a shield layer.

A hard mask is deposited on side walls of the first trench, a silicon dioxide dielectric layer with a thickness of 100 nm is deposited on a surface of the wafer by using a plasma enhanced chemical vapor deposition (PECVD) method, and 4.0×1013/cm3 P-type ions with a junction depth greater than 0.4 µm are injected into the bottom and the corners of the first trench by using an ion injection method.

After the shield layer is formed, all dielectrics on the surface are removed, a 20 nm carbon film dielectric layer is deposited, and high-temperature annealing processing is performed on the wafer, so as to activate ions injected into the epitaxial layer, the well region, the source region, the contact region, and the shield layer. The annealing processing is specifically, for example, RTA or RTP, which can reduce a time of temperature rise and cooling of the wafer, and improve activation efficiency. In addition, because the time is short, a distribution change of impurities can be further suppressed, and the impurities are prevented from spreading to another region. An annealing temperature is greater than or equal to 1600 degrees Celsius and less than a melting point of the substrate and the epitaxial layer. The annealing temperature may be specifically, for example, 1600 degrees Celsius, 1700 degrees Celsius, 1750 degrees Celsius, or the like. The carbon film is used to suppress the surface of the wafer from becoming rough in the process of high temperature annealing. After annealing, the carbon film is removed by using a plasma etching method.

307: Inject ions of the second conductivity type into the bottom wall and the trench corners of the first trench to form an amorphous semiconductor layer.

308: Grow a gate insulator in the first trench, and perform deposition and doping to form a gate of a poly gate structure.

309: Perform ohmic contact burying and wiring processing on the wafer.

Steps 307 to 309 are similar to steps 206 to 208, and therefore details are not described herein again.

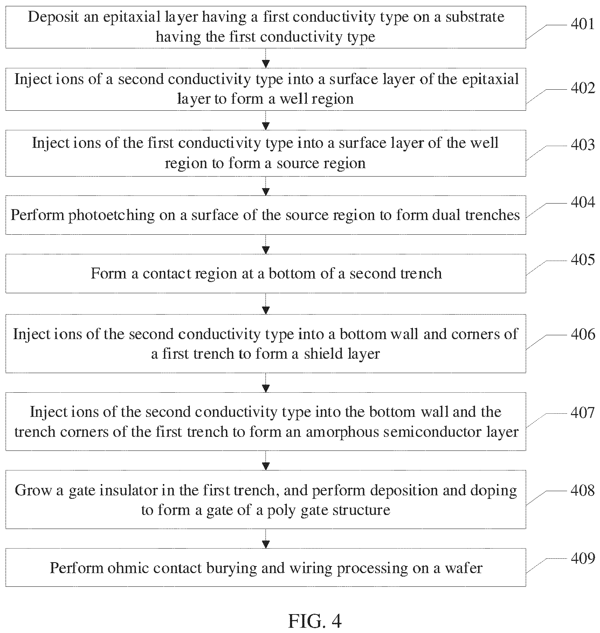

For a trench gate semiconductor device with dual trenches, FIG. 4 is a schematic flowchart of still another embodiment of a method for manufacturing a trench gate semiconductor device according to this application. A manufacturing process in this embodiment is as follows:
401: Deposit an epitaxial layer having a first conductivity type on a substrate having the first conductivity type.
402: Inject ions of the second conductivity type into a surface layer of the epitaxial layer to form a well region.
403: Inject ions of the first conductivity type into a surface layer of the well region to form a source region.

Steps 401 to 403 are the same as steps 301 to 303, and therefore details are not described herein again.

404: Perform photoetching on a surface of the source region to form dual trenches.

Photoetching is performed on the surface of the source region to form a first trench and a second trench. The first trench is used to form a gate in the first trench, and the second trench is used to form a contact region at a bottom of the second trench, and generate a part of a source in the second trench.

The first trench and the second trench may be etched simultaneously, or may be etched separately. A depth of the first trench is greater than a sum of thicknesses of the source region and the well region. A depth of the second trench is greater than a depth of the source region, and is less than the sum of thicknesses of the source region and the well region, so that a contact region is subsequently formed on a bottom wall of the second trench to connect to the well region.

405: Form the contact region at the bottom of the second trench.

A silicon dioxide dielectric layer with a thickness of approximately 1.5 µm is deposited on a surface of a wafer, and a part of the silicon dioxide dielectric layer on the surface of the wafer is selectively removed by using a photoetching or etching process, to form a contact region injection window, that is, the bottom wall of the second trench.

P-type impurities such as boron ions or aluminum ions are injected into the bottom wall of the second trench by using the contact area injection window by using an ion injection method, to form the contact area with a surface injection concentration greater than 1.0×1019/cm3. The P-type impurity injection concentration of the contact region is greater than an ion injection concentration of the well region.

406: Inject ions of the second conductivity type into the bottom wall and the corners of the trench to form a shield layer.

407: Inject ions of the second conductivity type into the bottom wall and trench corners of the trench to form an amorphous semiconductor layer.

408: Grow a gate insulator in the trench, and perform deposition and doping to form a gate of a poly gate structure.

409: Perform ohmic contact burying and wiring processing on the wafer.

Steps 406 to 409 are similar to steps 306 to 309, and therefore details are not described herein again.

In the trench gate semiconductor device provided in this application, a vertical trench gate structure is used, and channel mobility is improved by changing a channel direction, so that specific on resistance can be reduced. In addition, when the trench gate structure is used, a cell size can be reduced, current density can be improved, and specific on resistance can be reduced. The P+ shield layer and the amorphous semiconductor layer are used at the bottom of the trench gate to bear a reverse voltage, so as to reduce an electric field of a gate oxide film, thereby improving long-term use reliability of the gate oxide film. In addition, based on the device manufacturing method provided in this application, a manufacturing process is simple, and ion injection may be performed on the bottom of the trench after the trench is formed. To be specific, a requirement on a junction depth of the P+ shield layer and the amorphous semiconductor layer is not high, performance parameters of a process device are low, and manufacturing costs are low.

In the foregoing implementations, an example in which this application is applicable is described, but a design change or the like can be properly performed. For example, in the foregoing implementations, as an example of the gate insulator, an oxide film formed due to thermal oxidation is listed, but a film such as an oxide film or a nitride film that is not formed through thermal oxidation may alternatively be included. In addition, etching of the first trench may alternatively be performed before the well region, the source region, or the contact region is formed, or the like.

This application is described based on embodiments, but it should be understood that this application is not limited to the embodiments and structures. This application further includes various variant examples and variants within an equivalent range. Further, a plurality of combinations and forms, and other combinations and forms obtained by adding elements to or deleting elements from the combinations and forms are also included in the scope and the idea scope of this application.

## Claims

1. A trench gate semiconductor device, wherein the trench gate semiconductor device comprises:
a substrate having a first conductivity type;
an epitaxial layer having the first conductivity type, grown on the substrate;
a well region having a second conductivity type, formed on a surface layer of the epitaxial layer;
a source region having the first conductivity type, formed on a surface layer of the well region;
a first trench, running through the well region from a surface of the source region to the epitaxial layer;
a gate, formed in the first trench in a manner of being separated by a gate insulator; and
an amorphous semiconductor layer, formed in the first trench and wrapping an outer bottom wall of the gate and corners on two sides of the outer bottom wall in a manner of being separated by the gate insulator, wherein the amorphous semiconductor layer is made of a low dielectric constant material.

2. The trench gate semiconductor device according to claim 1, wherein a thickness of the amorphous semiconductor layer is greater than or equal to 0.1 µm.

3. The trench gate semiconductor device according to claim 1 or 2, wherein the trench gate semiconductor device further comprises:
a shield layer having the second conductivity type, formed on the epitaxial layer at a bottom of the first trench, wherein the shield layer wraps the amorphous semiconductor layer, and extends in an arc chamfer to the gate insulator on the corners or side walls of the gate.

4. The trench gate semiconductor device according to any one of claims 1 to 3, wherein a junction depth of the shield layer is greater than or equal to 0.4 µm.

5. The trench gate semiconductor device according to any one of claims 1 to 4, wherein the corner of the gate is arc-shaped on a longitudinal section of the first trench gate semiconductor device.

6. The trench gate semiconductor device according to any one of claims 1 to 5, wherein the epitaxial layer comprises a first sub epitaxial layer and a second sub epitaxial layer, the first sub epitaxial layer is located between the substrate and the second sub epitaxial layer, the well region, the source region, and the amorphous semiconductor layer are formed on the second sub epitaxial layer, and a doping concentration of the first sub epitaxial layer is less than a doping concentration of the substrate, and is greater than a doping concentration of the second sub epitaxial layer.

7. The trench gate semiconductor device according to any one of claims 1 to 6, wherein the trench gate semiconductor device further comprises:
a contact region having the second conductivity type, connected to the well region, wherein a doping concentration of the contact region is greater than a doping concentration of the well region;
a source, connected to the source region and the contact region; and
a drain, connected to a surface that is of the substrate and that is away from the epitaxial layer.

8. The trench gate semiconductor device according to any one of claims 1 to 7, wherein the first conductivity type is an N type, and the second conductivity type is a P type; or
the first conductivity type is the P type, and the second conductivity type is the N type.

9. The trench gate semiconductor device according to any one of claims 1 to 8, wherein a semiconductor material that forms the substrate and the epitaxial layer is silicon carbide, and/or the amorphous semiconductor is amorphous silicon carbide.

10. A method for manufacturing a trench gate semiconductor device, wherein the manufacturing method comprises:
depositing an epitaxial layer having a first conductivity type on a substrate having the first conductivity type;
injecting ions of a second conductivity type into a surface layer of the epitaxial layer to form a well region;
injecting ions of the first conductivity type into a surface layer of the well region to form a source region;
performing photoetching on a surface of the source region to form a first trench running through the well region to the epitaxial layer;
injecting ions of the second conductivity type into a bottom wall and trench corners of the first trench to form an amorphous semiconductor layer; and
growing a gate insulator in the first trench, and performing deposition and doping to form a gate of a poly gate structure.

11. The manufacturing method according to claim 10, wherein a thickness of the amorphous semiconductor layer is greater than or equal to 0.1 µm.

12. The manufacturing method according to claim 10 or 11, wherein before injecting the ions into the bottom wall and a part of a side wall of the first trench to form the amorphous semiconductor layer, the method comprises:
depositing a hard mask on side walls of the first trench; and
injecting ions of the second conductivity type into the bottom wall and the corners of the first trench to form a shield layer, wherein an injection depth of the shield layer is greater than an injection depth of the amorphous semiconductor layer, and a doping concentration of the shield layer is less than a doping concentration of the amorphous semiconductor layer.

13. The manufacturing method according to claim 12, wherein an injection junction depth of the shield layer is greater than or equal to 0.4 µm.

14. The manufacturing method according to any one of claims 10 to 13, wherein the corner of the gate is arc-shaped on a longitudinal section of the trench gate semiconductor device.
